# EUROPEAN PATENT SPECIFICATION

(11) **EP 0 492 773 B1**
(45) Date of publication and mention of the grant of the patent: **24.07.1996**
(21) Application number: 91308378.8
(22) Date of filing: 13.09.1991
(51) Int. Cl.: H01L 21/00, B05C 3/02

(54) **High temperature recirculating chemical bath construction**
Konstruktion eines heissen rezirkulierenden chemischen Bades
Construction de bain chimique recirculant à haute température

(30) Priority: 04.02.1991 US 650193; 26.12.1990 US 633690
(43) Date of publication of application: 01.07.1992
(73) Proprietor: IMTEC PRODUCTS INC., Sunnyvale, California 94089 (US)
(72) Inventor: Berman, Allan, Sunnyvale, California 94089 (US)
(74) Representative: Linn, Samuel Jonathan

(56) References cited:
- US-A- 4 350 553
- US-A- 4 578 137

## Description

This invention relates to chemical baths for immersing articles in liquid chemicals during manufacturing operations and more particularly to the sealing of the casing or housing of chemical baths of the type in which articles are exposed to a recirculating flow of hot liquid.

Various industrial operations require immersion of a product in hot liquids. In the electronics industry, for example, chemical baths are used for such purposes as etching and cleaning integrated circuit wafers. The liquid chemical must often be heated to a very high temperature and in many cases is highly corrosive. Thus certain components of the chemical bath must be formed of refractory materials which are also non-reactive to the liquid chemical.

A constant bath system for use in the manufacture of semiconductors is described in US 4 955 402 (H R Miranda). This concerns a tank having a rectangular container with a removable divider at at least one end of the container. In this way the divider separates the container into a large processing region and a second region from which liquid is drained from the container. The divider provides a weir over which liquid flows from the processing region into the 5 second region. Any contaminant particles which fall onto the surface of the liquid, and are momentarily trapped by surface tension, are removed from the processing region by the overflow action into the second region.

A bath system for etching semiconductors is also described in US 4 350 553 (P V Mendes). The system seeks to provide an effective seal between a vessel which is to contain acid, and a support housing for the vessel. The seal is provided by an elastomer located between a flange and lip on the vessel and an upstanding ledge on the support housing.

A particularly advantageous form of chemical bath for such purposes is described in my United States Patent 5 014 737 entitled "Quartz Integrated Trough/Sump Recirculating Filtered High-Purity Chemical Bath", the specification and drawings of which are hereby incorporated by reference. A chemical bath of that form includes a liquid chemical receptacle with a first compartment which functions as a processing vessel for receiving the articles to be treated and a second compartment which forms a sump. A trough extends along the upper region of the receptacle to carry overflow from the processing vessel to the sump and a pump recirculates a filtered flow of the liquid from the sump back to the processing vessel. The receptacle, including the processing compartment, sump and trough, is preferably a unitized single component formed of a refractory material such as quartz. The lower region of the receptacle is situated within a casing or housing formed of a less brittle material that can be more easily fabricated into the desired shape, any of various plastics being suitable for the purpose.

The junction between the receptacle and the rim of the casing should be sealed to prevent entry of liquids, corrosive vapor or other fluids. In the prior construction this is provided for by situating the underside of the trough immediately above the rim of the casing and adhering a quantity of sealing mastic to the trough and casing rim.

Such a seal bonds three different materials together, the quartz or the like, the casing plastic and the mastic itself, each of which undergoes a different degree of thermal expansion in response to heating. This creates stresses that limit the life of the seal. Repeated thermal cycling tends to break the bond between the sealing mastic and the other materials and to disintegrate the mastic itself, thereby necessitating frequent replacement. The construction also limits the maximum liquid temperature in the chemical bath as extreme differential expansion of the seal components can break the relatively brittle quartz or the like.

A chemical bath construction in which the seal is more durable in the presence of high liquid temperatures and which tolerates higher liquid temperatures would be highly advantageous.

The present invention is directed to overcoming one or more of the problems discussed above.

With this object in mind, the present invention provides a recirculating chemical bath as set out in the accompanying Claim 1.

The bath of the present invention includes a casing having a chamber and a receptacle having a lower region situated within the chamber of the casing and an upper region that extends above the rim of the casing. The receptacle has a first compartment forming a processing vessel for receiving the articles which are to be treated, a second compartment forming a sump for containing overflow from the processing vessel and a trough which extends along the processing vessel in position to receive the overflow and to carry the overflow to the sump. The trough is situated at a location on the receptacle that is above the casing rim and vertically spaced from the rim. The receptacle has an outwardly extending first flange overlying the casing rim, the flange being located below the trough and being vertically spaced from the trough. Sealing material is disposed at the underside of the flange in contact with both the flange and the casing rim. The bath further includes means for heating the liquid chemical and means for recirculating liquid chemical from the sump back to the processing vessel.

Preferred embodiments of the present invention have the features set out in the accompanying subsidiary claims.

The invention seens to provide a recirculating chemical bath configuration of the hereinbefore described general type in which the juncture between differing materials at the seal between the casing and the hot liquid chemical receptacle experiences less stress from thermal cycling. Components of the seal are situated away from the hot chemical flow in the overflow trough and do not receive heat by direct transfer through the floor of the trough. This makes the seal more durable and enables use of higher temperature liquids without damage to breakable components of the bath.

The invention, together with further aspects and advantages thereof, may he further understood by reference to the following description of the preferred embodiment and by reference to the accompanying drawings.

### Brief Description of the Drawings

FIG. 1 is a perspective view of a high temperature recirculating chemical bath embodying the invention.

FIG. 2 is a cross section view of the chemical bath taken along line 2-2 of FIG. 1.

FIG. 3 is a partially broken out side elevation view of the chemical bath of FIG. 1 with certain components of the liquid recirculation system being shown in schematic form.

FIG. 4 is a top view of the apparatus of the preceding figures.

FIG. 5 is an enlarged cross sectional view of the portion of the apparatus encircled by dashed line 5 in FIG. 2.

### EMBODIMENTS OF THE PRESENT INVENTION

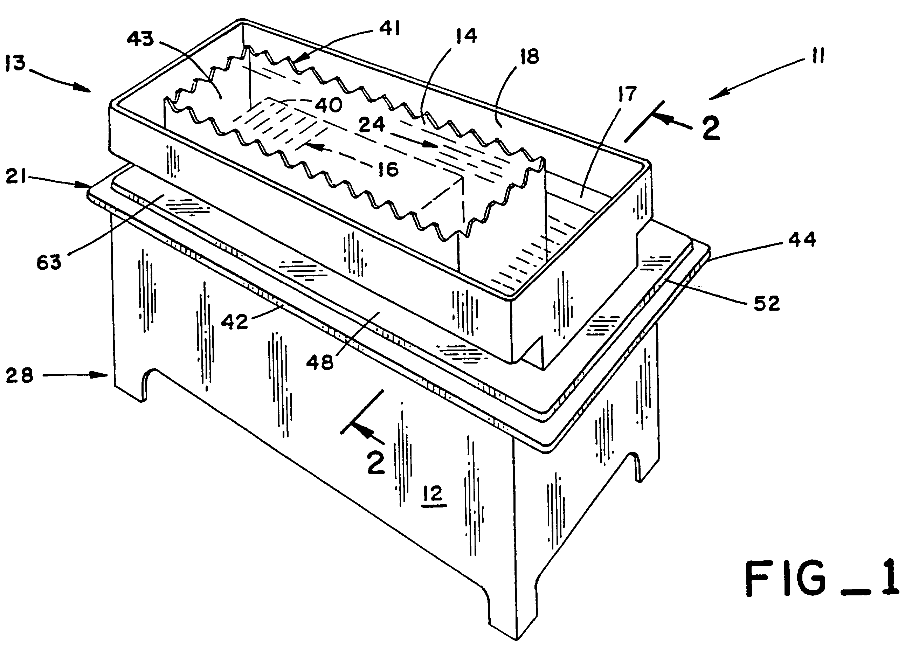

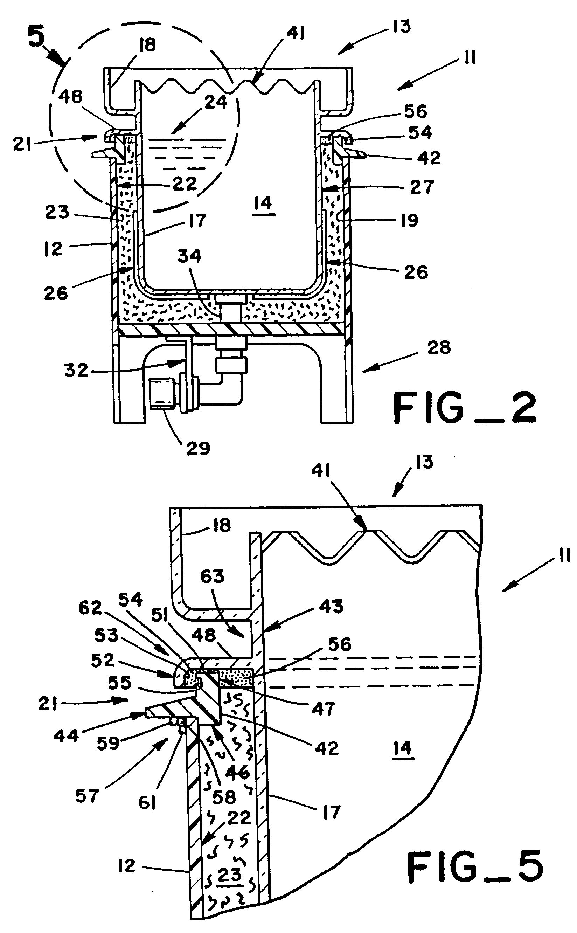

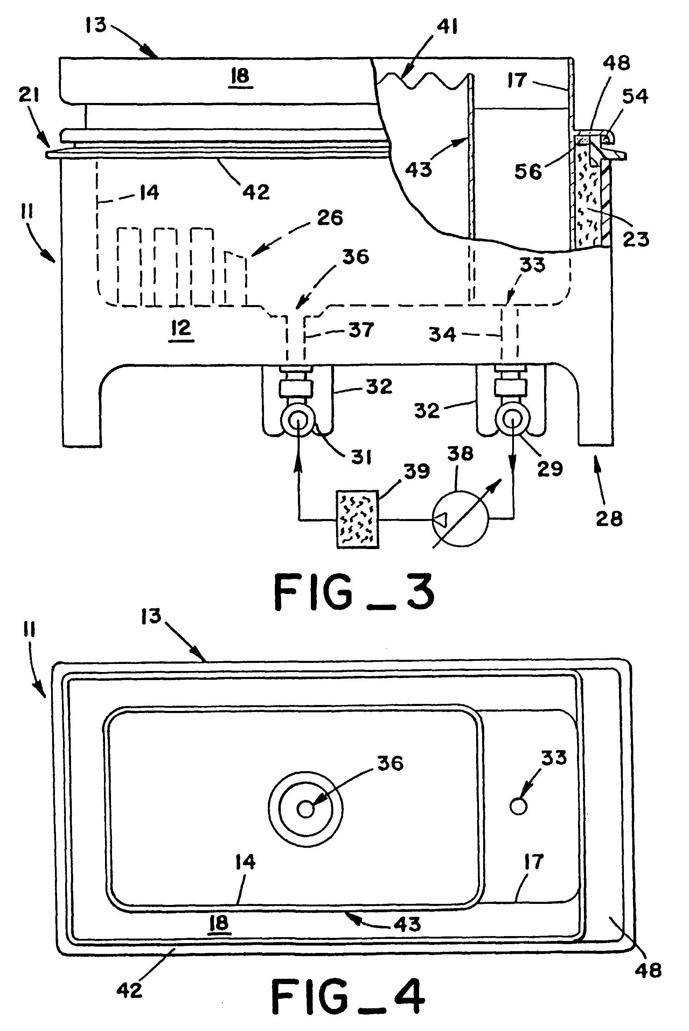

Referring initially to FIG. 1 of the drawings, components of a recirculating chemical bath 11 embodying the invention include an external housing or casing 12 and a liquid chemical receptacle 13 which is supported by the casing. Receptacle 13 has a first compartment which functions as a processing vessel 14 for receiving articles 16 that are to be treated in the chemical bath 11 and an adjacent second compartment which is a sump 17 for containing liquid chemical that overflows from the processing vessel. The overflow is received and carried to the sump 17 by an inclined trough 18 which extends across one end of the processing vessel, along both sides of the processing vessel and along both sides of the sump 17 at the opposite end of the processing vessel.

Referring to FIGS. 2, 3 and 4 in conjunction, the casing 12 and receptacle 13 have a generally rectangular shape in this embodiment of the invention although other configurations are also possible. Casing 12 forms a rectangular chamber 19 in which the lower and intermediate regions of the receptacle 13 are received and seated. The upper portions of receptacle 13 extend above casing 12 and the trough 18 is situated above the rim 21 of the casing and is spaced apart from the casing rim in the vertical direction to isolate the trough from the rim.

The receptacle 13, including processing vessel 14, sump 17 and trough 18, is preferably an integral body of refractory material of a type that is chemically non-reactive with the liquids that are used in the bath. The receptacle 13 may, for example, he formed by fusing quartz plates together in instances where the bath 11 is to be used for processing integrated circuit wafers 16. Casing 12 is formed of a different material that is less brittle and which can be more easily fabricated into the desired shape, polypropylene plastic being a suitable example.

The interior chamber 19 of casing 12 is somewhat broader and longer than receptacle 13 to provide space between the receptacle and the chamber walls 22 in which thermal insulation 23 is disposed. The liquid chemical 24 within the bath 11 is heated by a series of band-like electrical heating elements 26 of the resistive type which are disposed against the bottom and the lower portions of the outer walls 27 of the processing vessel 14 region of receptacle 13.

Casing 12 has a support leg 28 at each lower corner of the casing to provide space beneath the receptacle 13 for a flow outlet fitting 29 and flow inlet fitting 31 which are secured to the underside of the casing by mounting brackets 32. Outlet fitting 29 is communicated with an opening 33 at the bottom of sump 17 through a pipe 34 and inlet fitting 31 communicates with an opening 36 at the center of the base of processing vessel 14 through another pipe 37.

A pump 38 draws liquid chemical from the sump 17 through fitting 29 and pipe 34, directs the liquid through a filter 39 and recirculates the filtered liquid back into processing vessel 14 through fitting 31 and pipe 37. Thus a continuous flow of heated liquid chemical 24 travels upward within processing vessel 14 and then overflows into trough 18 which carries the overflow back to the sump 17. The upper edge 41 of processing vessel 14 is scalloped in this embodiment to assure an even distribution of the overflow around the perimeter of the processing vessel. This acts to equalize the flow rate past articles 16 that are located at different regions of the processing vessel 14. The volume of liquid chemical in the bath 11 is such that the sump 17 is only partially filled prior to immersion of the wafers or other articles 16 in the processing vessel 14. Thus, with reference again to FIG. 1, the sump 17 is able to contain the liquid that is displaced from processing vessel 14 as the articles 16 and article carrier 40 are being immersed. Liquid level in processing vessel 14 temporarily drops and overflow temporarily ceases when a batch of articles 16 is removed from the bath 11. The sump 17 also serves to avoid pump starvation during such periods.

Referring to FIG. 5, the rim 21 of casing 12 is defined by a rim member 42 which extends around the perimeter of the casing at the top of the casing wall 22. Rim member 42 has a flange like base portion 44 which straddles the top of the casing wall 43 and which extends a short distance outward from the wall to assure that the receptacle 13 is not impacted against nearby structural walls or equipment. Another portion 46 of rim member 42 extends a short distance downward from base portion 44 at a location which is just inside the casing wall 43. Still another portion 47 extends upward from the base portion 44 at a location above portion 46.

Receptacle 13 is secured to the casing 12 though a flange 48 which extends outward from the receptacle and which overlays the top of portion 47 of casing rim member 42, a corrugated spacer 51 being disposed between the flange and portion 47 to provide cushioning at the juncture of the flange and rim member. Flange 48 extends outwardly a small distance beyond portion 47 of the rim member 42 and has a downwardly directed lip 52 at the outer edge forming a pocket 53 in which sealing mastic 54 is disposed and bonded to both the flange 48 and the rim member to prevent entry of liquid and vapors into the casing 12. The mastic 54 extends into a horizontal groove 55 in rim member portion 47 to mechanically lock the mastic in place. Another volume 56 of the sealing mastic extends between rim member portion 47 and receptacle 13 and is adhered to portion 47, the receptacle wall and the underside of flange 48.

Flange 48 is an integrated portion of the receptacle 13 and is formed of the same refractory material such as quartz. As such materials tend to be relatively brittle and breakable, It is desirable to isolate the receptacle 13 including flange 48 from stresses that might otherwise be exerted or, the receptacle by flexing of the plastic material of casing 12. For this purpose, the rim member is secured to the top of casing wall 43 by a triple bead plastic weld 57. Weld 57 includes an inner bead 58 at the outer juncture of flange 48 and rim member 42, a second head 59 bonded to bead 58 and the underside of flange 48 and a third bead 61 bonded to the inner bead 58 and rim member portion 47. The second and third beads 59 and 61 are slightly separated from each other.

As the plastic material of which the weld 57 is formed is slightly flexible when in the above described configuration, the weld acts as a hinge enabling a small degree of rocking motion of rim member 42 relative to casing wall 43. This enables the rim member 42 to accomodate to flexing of the casing wall 43 without stressing of the quartz flange 48.

As previously discussed, the seal formed by mastic 54 and 56 bonds components, rim member 42 and flange 48, formed of different materials that exhibit different degrees of thermal expansion upon being heated and the mastic itself may have still another coefficient of thermal expansion. Repeated differential expansion of the three materials in response to very high heat inputs causes a mechanical working of the polymerized mastic 54, 56 that can lead to early failure of the sealing mastic both in the integrity of its body and in its adhesion to the adjacent quartz and plastic materials. Heat input to the components which form the casing seal 62 is minimized, thereby lengthening the life of the seal, by the flange 48 which is vertically spaced apart from the underside of trough 18. Heat is not directly transferred from hot liquid in trough 18 to the mastic 54, 56 through the floor of the trough as in the above described prior construction of chemical baths of this general type. In addition, cooling air may circulate in the region 63 immediately above the quartz flange 48 and remove heat which is conducted to the seal 62 from the processing vessel 14. In further contrast to the prior construction, trough 10 is not subjected to potentially damaging mechanical stress caused by differential expansion of components of the seal 62.

The chemical bath 11 has been herein described with reference to the processing of batches of integrated circuit wafers 16. The bath construction is adaptable to processing of diverse other products which need to be immersed in a heated liquid for etching, cleaning or for other purposes and to operations where articles may be continuously fed into and removed from the bath by a conveyor or the like.

## Claims

1. A recirculating chemical bath (11) for immersing articles (16) in a flow of hot liquid chemical (24) comprising:
a casing (12) having a chamber (19) and a rim (21) which extends around the perimeter of the chamber (19) at the upper end thereof; and
a liquid chemical receptacle (13) having a first compartment forming a processing vessel (14) for receiving the articles (16) and a second compartment forming a sump (17) for containing liquid chemical which overflows from the processing vessel (14), means (38) for recirculating liquid chemical overflowing into the sump (17) back to the processing vessel (14) and means (26) for heating said liquid chemical (24), said receptacle (13) having a lower region situated within the chamber (19) and an upper region which extends above the rim (21) of the casing (12), characterised in that the receptacle (13) has a trough (18) extending along the processing vessel (14) in position to receive liquid chemical overflow therefrom and to carry the overflow to the sump (17), the trough (18) being at a location on the receptacle (13) that is above the casing rim (21) and vertically spaced apart therefrom, a first flange (48) extends outwardly from the receptacle (13) and overlies the casing rim (21) , the casing rim (21) engages the first flange (48) in supporting relationship, the first flange (48) is disposed below trough (18) and vertically spaced apart therefrom, and
sealing material (54) is disposed at the underside of the first flange (48) and contacting both the underside of the flange (48) and the casing rim (21) to seal the first flange (48) to the casing rim (21).

2. A bath according to Claim 1, wherein the processing vessel (14), sump (17) and trough (18) are a unitary body of refractory material.

3. A bath according to claim 1 or 2, wherein the flange (48) is an integral portion of the receptacle (13) .

4. A bath according to any preceding claim, wherein the casing (12) has upwardly extending sidewalls (22) and wherein the rim (21) of the casing (12) is formed by a second flanged rim member (42) which extends around the perimeter of the casing chamber (19) at the top of said sidewall (22) and which is secured thereto, the rim member (42) being bonded to the underside of the first flange (48) by sealing material (54).

5. A bath according to Claim 4 wherein the first flange (48) has a downwardly directed lip (52) at its outer edge forming an inverted pocket (53) at the underside of the first flange (48) and wherein an upwardly directed portion (47) of the rim member (42) extends into the pocket (53), the sealing material (54) being disposed in the pocket (53) at each side of the upwardly directed portion (47) of the rim member (42).

6. A bath according to any preceding claim, wherein the trough (18) has a floor which extends outwardly from the receptacle (13) and an outer wall which extends upward from the outer edge of said floor, and wherein the floor of the trough (18) is vertically spaced above the first flange (48).

7. A bath according to Claim 6 wherein a region (63) between the floor of the trough (18) and the first flange (48) is open to air circulation.

8. A bath according to any preceding claim wherein the heating means (26) for heating liquid chemical (24) are disposed against the bottom and the lower portions of the outer walls (27) of the processing vessel (14).

## Patentansprüche

1. Chemisches Wiederumlauf-Bad (11) zum Eintauchen von Gegenständen (16) in einen Strom heißer flüssiger Chemikalie (24), umfassend:
ein Gehäuse (12) mit einer Kammer (19) und einem Rand (21), der sich an deren oberem Ende um den Umfang der Kammer (19) erstreckt; und
ein Behältnis (13) für flüssige Chemikalie mit einem ersten Abteil, das ein Behandlungsgefäß (14) zum Aufnehmen der Gegenstände (16) bildet und einem zweiten Abteil, das einen Sumpf (17) zum Aufnehmen von flüssiger Chemikalie, die aus dem Behandlungsgefäß (14) überläuft, bildet, Mittel (38) zum Zurückführen von flüssiger Chemikalie, die in den Sumpf (17) überläuft, in das Behandlungsgefäß (14), sowie Mittel (26) zum Erhitzen der flüssigen Chemikalie (24), wobei das Behältnis (13) einen unteren Bereich, der sich innerhalb der Kammer (19) befindet, sowie einen oberen Bereich, der sich über den Rand (21) des Gehäuses (12) erstreckt, aufweist, dadurch gekennzeichnet, daß das Behältnis (13) eine Wanne (18) aufweist, die sich entlang des Behandlungsgefäßes (14) in einer solchen Position erstreckt, daß die daraus überlaufende flüssige Chemikalie aufgenommen und zum Sumpf (17) befördert wird, wobei sich die Wanne (18) in einer Position auf dem Behältnis (13) befindet, die über dem Gehäuserand (21) und vertikal davon beabstandet liegt, ein erster Flansch (48) sich vom Behältnis (13) nach außen erstreckt und über dem Gehäuserand (21) liegt, der Gehäuserand (21) am ersten Flansch (48) in tragender Beziehung angreift, der erste Flansch (48) unter der Wanne (48) angeordnet und vertikal davon beabstandet ist, und
Dichtungsmaterial (54) an der Unterseite des ersten Flansches (48) angeordnet ist und sowohl die Unterseite des Flansches (48) als auch den Gehäuserand (21) berührt, um den ersten Flansch (48) dicht mit dem Gehäuserand (21) zu verbinden.

2. Bad nach Anspruch 1, worin das Behandlungsgefäß (14), der Sumpf (17) und die Wanne (18) ein einheitlicher Körper aus feuerfestem Material sind.

3. Bad nach Anspruch 1 oder 2, worin der Flansch (48) ein einstückiger Abschnitt des Behältnisses (13) ist.

4. Bad nach einem der vorangegangenen Ansprüche, worin das Gehäuse (12) sich nach oben erstreckende Seitenwände (22) aufweist und worin der Rand (21) des Gehäuses (12) aus einem zweiten Randelement (42) mit Flansch gebildet ist, das sich an der Oberseite der Seitenwand (22) um den Umfang des Gehäuseelements (19) erstreckt und daran befestigt ist, wobei das Randelement (42) durch Dichtungsmaterial (54) mit der Unterseite des ersten Flansches (48) verbunden ist.

5. Bad nach Anspruch 4, worin der erste Flansch (48) eine nach unten gerichtete Lippe (52) an seiner Außenkante aufweist, die eine umgekehrte Tasche (53) an der Unterseite des ersten Flansches (48) bildet und worin sich ein nach oben gerichteter Abschnitt (47) des Randelements (42) in die Tasche (53) erstreckt, wobei das Dichtungsmaterial (54) in der Tasche (53) an jeder Seite des nach oben gerichteten Abschnitts (47) des Randelements (42) angeordnet ist.

6. Bad nach einem der vorangegangenen Ansprüche, worin die Wanne (18) einen Boden aufweist, der sich vom Behältnis (13) nach außen erstreckt, sowie eine Außenwand, die sich von der Außenkante des Bodens nach oben erstreckt, und worin der Boden der Wanne (18) vertikal über dem ersten Flansch (48) beabstandet ist.

7. Bad nach Anspruch 6, worin ein Bereich (63) zwischen dem Boden der Wanne (18) und dem ersten Flansch (48) für Luftzirkulation offen ist.

8. Bad nach einem der vorangegangenen Ansprüche, worin die Heizmittel (26) zum Erhitzen flüssiger Chemikalie (24) am Boden und an den unteren Abschnitten der Außenwände (27) des Behandlungsgefäßes (14) angeordnet sind.

## Revendications

1. Bain (11) chimique de recirculation pour immerger des articles (16) dans un flot de produit chimique (24) liquide chaud comprenant :
un logement (12) ayant une chambre (19) et une bordure (21) qui s'étend autour du périmètre de la chambre (19) à son extrémité supérieure; et
un réceptacle (13) de produit chimique liquide ayant un premier compartiment formant un récipient de traitement (14) pour recevoir les articles (16) et un second compartiment formant un récipient de réception (17) pour contenir le produit chimique liquide qui déborde du récipient (14) de traitement, un moyen (38) pour la recirculation du produit chimique liquide débordant dans le récipient de réception (17) en retour au récipient (14) de traitement et un moyen (26) pour chauffer ledit produit chimique (24) liquide, ledit réceptacle (13) ayant une région inférieure située dans la chambre (19) et une région supérieure qui s'étend au-dessus de la bordure (21) du logement (12), caractérisé en ce que le réceptacle (13) a un passage (18) s'étendant le long du récipient (14) de traitement en position pour recevoir le débordement du produit chimique liquide provenant de celui-ci et pour transporter le débordement vers le récipient de réception (17), le passage (18) étant à un endroit sur le réceptacle (13) qui est au-dessus de la bordure (21) du logement et espacé verticalement de celle-ci, une première bride (48) s'étend vers l'extérieur du réceptacle (13) et recouvre la bordure (21) du logement, la bordure (21) du logement s'engage dans la première bride (48) en une relation de support, la première bride (48) est disposée en dessous du passage (18) et verticalement espacée de celui-ci, et
un matériau de scellement (54) est disposé sur le côté en dessous de la première bride (48) et contactant à la fois le côté en dessous de la bride (48) et la bordure (21) du logement pour sceller la première bride (48) à la bordure (21) du logement.

2. Bain selon la revendication 1, dans lequel le récipient (14) de traitement, le récipient de réception (17) et le passage (18) sont un corps unitaire d'un matériau réfractaire.

3. Bain selon la revendication 1 ou 2, dans lequel la bride (48) est une portion intégrale du réceptacle (13).

4. Bain selon l'une quelconque des revendications précédentes, dans lequel le logement (12) a des parois latérales (22) s'étendant vers le haut et dans lequel la bordure (21) du logement (12) est formée par un second membre (42) de bordure bridée qui s'étend autour du périmètre de la chambre (19) du logement au sommet de ladite paroi latérale (22) et qui est fixé à celle-ci, le membre (42) de bordure étant lié au côté en dessous de la première bride (48) par un matériau (54) de scellement.

5. Bain selon la revendication 4 dans lequel la première bride (48) a une lèvre (52) dirigée vers le bas sur son bord externe formant une poche (53) inversée sur le côté en dessous de la première bride (48) et où une portion (47) dirigée vers le haut du membre (42) de la bordure s'étend dans la poche (53), le matériau de scellement (54) étant disposé dans la poche (53) sur chaque côté de la portion (47) dirigée vers le haut du membre (42) de bordure.

6. Bain selon l'une quelconque des revendications précédentes, dans lequel le passage (18) a un plancher qui s'étend vers l'extérieur à partir du réceptacle (13) et une paroi externe qui s'étend vers le haut à partir du bord externe dudit plancher, et dans lequel le plancher du passage (18) est verticalement espacé au-dessus de la première bride (48).

7. Bain selon la revendication 6 dans lequel une région (63) entre le plancher du passage (18) et la première bride (48) est ouverte à une circulation d'air.

8. Bain selon l'une quelconque des revendications précédentes dans lequel le moyen (26) de chauffage pour chauffer le produit chimique (24) liquide est disposé contre les portions de fond et inférieures des parois externes (27) du récipient (14) de traitement.
